(19) Europäisches Patentamt

European Patent Office

Office européen des brevets

(11) **EP 4 198 532 A1**

(12) **EUROPEAN PATENT APPLICATION**

(43) Date of publication:
21.06.2023 Bulletin 2023/25

(21) Application number: 21215613.7

(22) Date of filing: 17.12.2021

(51) International Patent Classification (IPC):
**G01R 31/367** (2019.01)    G01R 31/3835 (2019.01)
**G01R 31/392** (2019.01)

(52) Cooperative Patent Classification (CPC):
**G01R 31/367;** G01R 31/3835; G01R 31/392

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **VITO NV**
**2400 Mol (BE)**

(72) Inventors:
• **Fekriasl, Sajjad**
**2400 Mol (BE)**
• **Coenen, Peter**
**2400 Mol (BE)**
• **Mulder, Grietus**
**2400 Mol (BE)**
• **Capron, Odile**
**2400 Mol (BE)**

(74) Representative: **V.O.**
**P.O. Box 87930**
**2508 DH Den Haag (NL)**

(54) **A COMPUTER IMPLEMENTED METHOD AND A SYSTEM FOR DETERMINING ELECTROMOTIVE FORCE CURVES OF A BATTERY**

(57)    The invention relates to a method and system for determining an electromotive force curve of a battery for use in battery control applications. Measured data is received identifying an electromotive force for a plurality of state of charge values of the battery. A fitting processing is performed by using a curve fitting model for determining an electromotive force curve based on the measured data, the electromotive force curve indicating a continuous relationship between the electromotive force and a state of charge of the battery. The curve fitting model includes a fitting function consisting of only differentiable terms.

FIG 2

**Description**

FIELD OF THE INVENTION

The invention relates to a computer implemented method and a system for determining electromotive force curves of a battery for use in battery control applications. Furthermore, the invention relates to a battery unit. Also, the invention relates to an electrical system comprising a battery unit. Additionally, the invention relates to a computer program product.

BACKGROUND TO THE INVENTION

Batteries are widely used in various systems and devices. The supervision of batteries by a battery management system often relies on fast and accurate simulation models. Mostly equivalent circuit models are used. Often, the simulation models utilize the electromotive force (EMF) curve of batteries. The EMF curve describe a continuous relationship between the electromotive force and the state of charge (SoC) of the battery. In some examples, the EMF curve is stored as a look-up table. Such approach may be inaccurate and/or inefficient, and it may impose some requirements on the hardware used for processing the data.

The state of charge (SoC) is defined as the integral of the current (cf. Coulomb) divided by the capacity of the battery cell. The capacity of the battery is function of its internal components, materials, configuration, dimensions/size, ageing, and temperature, to name a few. Most of these can change over time for individual battery cells. For example, when the temperature is cold, the resistance typically gets higher, resulting in a significant drop in voltage. Various factors such as temperature, ageing, etc. can also impact/influence the EMF curve.

The EMF curve of a battery can be considered as a key element for battery applications that can contain a high level of detail. It may be unfeasible to capture such detail by straightforward differentiable mathematical equations. However, such level of detail may, however, be essential in deriving battery state information by tracking measurements, such as for example exact SoC.

In the known art, the EMF curves are often fitted using models such as polynomials, genetic algorithms or machine learning techniques. However, such an approach typically lacks efficiency and may be unfeasible to use in various applications. For example, the use of genetic algorithms may require massive data in order to obtain accurate results. There is a strong need for a more efficient solution.

There is a desire to improve the way the EMF curve is determined and/or estimated using measurement data, and to improve estimation/determination of the SoC and/or state of health (SoH) of batteries using said determined/estimated EMF curve.

SUMMARY OF THE INVENTION

It is an object of the invention to provide for a method and a system that obviates at least one of the above mentioned drawbacks.

Additionally or alternatively, it is an object of the invention to improve the determination of electromotive force curves of a battery for use in battery control and/or analysis.

Additionally or alternatively, it is an object of the invention to provide a more efficient and/or accurate way of determining the SoC and/or SoH of batteries.

Additionally or alternatively, it is an object of the invention to provide for more accurate incremental capacity analysis.

Thereto, the invention provides for a computer implemented method of determining electromotive force curve of a battery for use in battery control and/or analysis, the method comprising: receiving measured data identifying an electromotive force for a plurality of state of charge values of the battery; and performing fitting processing by using a curve fitting model for determining an electromotive force curve based on the measured data, the electromotive force curve indicating a continuous relationship between the electromotive force and a state of charge of the battery; and wherein the curve fitting model includes a fitting function consisting of only differentiable terms.

It is important to have a good knowledge of the EMF curve for battery control and/or analysis. Even batteries cells of the same type may have different EMF curve. The derivative of the EMF curve can be important for various applications. The computer implemented method enables a more accurate determination of the derivative of the EMF curve.

For example, the fitting model can be employed for fitting an EMF curve which is subsequently used in ICA analysis. As a result, an aging analysis for the battery cell can be performed in a highly accurate way.

Optionally, the fitting function of the curve fitting model includes a constant part, a linear part, an exponential part and a periodic part.

The fitting model with a fitting function with such parts/terms can result in an efficient and accurate determination/estimation of the electromotive force curve. The fitting function is suited for fitting battery EMF curves based on measurement data.

Advantageously, the fitting function model takes into account the physics of the batteries and is very suited for determining the EMF curve. As a result, a highly accurate EMF curve can be obtained, which is suited for various further applications, for instance using the derivative of the EMF curve (cf. d(EMF)/d(SoC) versus SoC, or the like).

Optionally, the periodic part is represented by trigonometric terms, wherein the periodic part of the fitting function of the curve fitting model includes one or more damped trigonometric terms and one or more non-damped trigonometric terms.

The dynamics of batteries or battery cells can be complex. Often, same battery cells may have different characteristics, resulting in different EMF curves. The fitting function with the one or more damped trigonometric terms and one or more non-damped trigonometric terms can better capture the dynamics of the battery or battery cell, resulting in improved EMF curve fitting.

Optionally, during the fitting processing a fitting error is calculated, and wherein parameters of the fitting function are adjusted in order to reduce the fitting error below a threshold fitting error value.

Optionally, the fitting function includes a Fourier series. The fitting function may be configured to capture a dynamic frequency behavior. In this way, the dynamics of the battery can be captured at different frequencies for enabling an improved determination of the EMF curve using the fitting model.

Experimental data can be received and fitted into a model using the mathematical equation provided above in order to better capture the battery dynamics and/or characteristics of the battery.

Optionally, the fitting function of the curve fitting model is given by:

$$E(x) = \alpha_0 + \alpha_1 x + \beta_0 e^{-\delta_0 x} + \beta_1 e^{-\delta_1 x} \cos(m_1 x + \theta_1) + \sum_{k=1}^{N} r_k \cos(k\omega x + \varphi_k)$$

wherein:

$E$ is the electromotive force; $x$ is the state of charge; $\alpha$, $r_k$ $\delta_k$, $\omega_k$, $\varphi_k$, $\beta$, and m are fitting parameters; and $N$ is an order.

The fitting function of the fitting model is tailored to battery EMF curves, resulting in highly accurate EMF curve fits. The dynamics of the battery chemistries are better captured using the EMF curve fitting model. For example, the fitting model can capture both low frequency and high frequency oscillations.

It will be appreciated that an equivalent equation can be employed. The equation can be reshaped or reformulated in various ways. Various equivalent fitting functions can be used. For example, trigonometric terms may be formulated in their exponential form, and/or vice versa. For example, the exponential part of the fitting function can be formulated mathematically in an equivalent way. Optionally, the fitting function includes additional terms, for example for certain battery chemistries.

Optionally, the order N results in N trigonometric terms in the fitting function corresponding to non-damped modes.

In the above equation, the right term is a Fourier series. The trigonometric series with damping term are not Fourier series. A subset of the harmonics may be considered the fundamental harmonics for the chemistry of the battery cell. By means of the tailored made curve fitting model according to the disclosure such fundamental harmonics can be effectively identified.

In some examples, the fitting function is further simplified and/or generalized.

In some examples, solving equations can be much more time efficient. It can facilitate fixed point calculations, needing less costly hardware.

Optionally, the fitting function of the curve fitting model is given by:

$$E(x) = \alpha_0 + \alpha_1 x + \sum_{k=0}^{N+1} r_k e^{\delta_k x} \cos(\omega_k x + \varphi_k)$$

wherein:

$E$ is the electromotive force; $x$ is the state of charge; $\alpha$, $r_k$, $\delta_k$, $\omega_k$ and $\varphi_k$ are fitting parameters; and $N$ is an order.

The above equation is a more compact form for the fitting function. The fitting model enables a highly accurate EMF curve estimation/determination. Moreover, since the fitting by means of the fitting model is improved, also the derivative of the EMF versus SoC and/or vice versa (SoC versus EMF) is highly accurate.

Optionally, the order N is at least 8, preferably at least 10, even more preferably at least 15.

As a result, an accurate fitted continuous EMF curve can be obtained. The continuity obtained in the smooth EMF curve results in a more accurate determination of the derivative of the EMF curve, which can be used for example in incremental capacity analysis, SoC estimation applications, etc.

Optionally, the order N is selected based on a type of battery cell, wherein preferably N is in a range of 10 to 60, more preferably in a range of 15 to 45.

The selection of the order may play an important role in the effectiveness of the EMF curve fitting. From experimental results it has been observed that such ranges of the order N can provide good results for most battery chemistries. Although a higher order N may result in a higher accuracy, it is observed that the order N can be selected to provide sufficient accuracy whilst enabling an effective way to perform the EMF curve fitting. In some examples, the order N is preferably in a range between 30 and 45, more preferably between 35 and 40.

Optionally, fitting errors are calculated for multiple different orders N during the fitting processing.

This allows to determine an adequate order N. The selected order N may for instance be different for different batteries, different battery chemistries, etc.

Optionally, one or more first values are calculated indicative of first errors in fitting the EMF curve, wherein one or more second values are calculated indicative of second errors in approximation of at least one of: d(Electromotive force)/d(State of Charge) curve or an incremental capacity analysis, wherein the one or more first values and one or more second values are calculated for different order N, wherein the order N is selected based on the one or more first values and the one or more second values.

Advantageously, both first values and the second values are effectively taken into account for selecting an the order N. This provides a coupled way of taking into account the accuracy of EMF fitting and derivative calculations An implicit filtering can be obtained for both the EMF curve and the derivative calculations.In some examples, a too large order N is not desired. A larger order N may result in less errors. However, the complexity may be too high. It is advantageous to select the order N such as to find a balance in quality and complexity of the fitting for both the EMF and the derivative calculations.

For example, the derivative of the measured EMF curve may be noisy, even with an adequate fitting of the EMF curve. By taking into account also the derivative calculations in fine tuning the order N, the model can be used for providing more accurate results for various applications since more accurate derivative calculations (cf. d(EMF)/d(SOC), d(V)/d(Q), d(Q)/d(V)) are obtained. In this way, the action of filtering can be performed inherently. This provides significant advantages compared to the case of sole filtering of the measurement data prior to fitting. Such separate filtering step is decoupled and may not be adequate for providing adequate derivative calculations.

Optionally, the method includes starting with a higher order N value and repeatedly performs subsequent calculations for lower order N values until the metric and/or error fails to be within a desired range (cf. threshold, limits, etc.). For example, the method may include starting with larger order N and reducing the order N until it results in satisfactory performance for at least one of the three curves indicative of d(EMF)/d(SOC), d(V)/d(Q), d(Q)/d(V). In some examples, curves indicative of d(EMF)/d(SOC) and at least one of d(V)/d(Q) or d(Q)/d(V) are taken into account.

Optionally, the method includes starting with a lower order N value and repeatedly performing subsequent calculations for higher order N values until the metric and/or error falls within a desired range (cf. threshold, limits, etc.). For example, the method may include starting with smaller order N values and increasing it until it gives good performance for at least one of the three curves indicative of d(EMF)/d(SOC), d(V)/d(Q), d(Q)/d(V). In some examples, curves indicative of d(EMF)/d(SOC) and at least one of d(V)/d(Q) or d(Q)/d(V) are taken into account.

It will be appreciated that various metrics may be used for evaluating the quality of the fitting of the EMF curve and the derivative calculations (e.g. d(EMF)/d(SOC) curve, d(V)/d(Q), and/or d(Q)/d(V)). For example, the metric may be based on one or more types of errors. Exemplary metrics are squared error, maximum error, mean error, RMS, absolute errors, etc. Various other metrics can be used. A combination of different metrics may also be used. In some examples, one or more quality models are used for calculating a quality of approximation based on comparison with experimental data. In some examples, the quality model is a statistical model. The metric may be associated to multiple data points, a subset of available of datapoints, or all available datapoints. Various techniques for determining metrics and/or error values are envisaged. Furthermore various acceptable ranges and/or thresholds for said metrics and/or errors can be used.

Therefore, in some advantageous embodiments, not only fitting of the EMF curve is performed, but also derivatives coupled to the EMF curves are actively taken into account for selecting the order N. The measurement data may be noisy for instance at least partially induced by the used sensors. Such noise may have significant detrimental effects on the applications involving the calculation of the derivative (e.g. incremental capacity analysis, d(EMF)/d(SOC), and the like). Hence, an exact fitting may not be appropriate. However, an adequate order N can be selected by taking into account both the one or more first values associated to fitting errors of the EMF curve and the one or more second values linked to errors of approximating at least one of: of: d(Electromotive force)/d(State of Charge) curve or incremental capacity analysis (cf. dV/dQ and/or dQ/dV).

Optionally, the determined battery electromotive force curve is usable for Incremental Capacity Analysis (ICA), wherein the incremental capacity analysis is based on a mathematical derivative of the fitting function.

Optionally, the incremental capacity analysis includes calculating dQ/dV and/or dV/dQ, wherein dQ is the step difference between the charge and dV is the step difference of the voltage. In some cases, incremental capacity analysis is understood to involve a determination of dQ/dV, whilst differential voltage analysis is understood to involve a determination of dV/dQ. In this disclosure, incremental capacity analysis also includes differential voltage analysis.

Once an exact expression is available, the Incremental Capacity Analysis (ICA) can become more accurate as well. ICA is used to follow-up battery ageing by comparing the shift and decrease of peaks in a dQ/dV against voltage representation. The calculation of $\Delta Q/\Delta V$ from measurement data leads to noisy data since small noise on the voltage data is exploded. The exact expression leads inherently to beautiful characteristics. Data analysis becomes appreciably easier to interpret. More importantly, having an EMF precise mathematical expression can result in a more accurate State-of-Health (SOH) estimation of the battery/cell.

Optionally, the determined battery electromotive force curve is usable for a state of charge (SOC) estimation and/or state of health (SOH) estimation of the battery.

A EMF curve (i.e. EMF versus SoC) can be seen as one of the key elements in various battery applications, such as for instance battery state of charge estimation.

Often, the measurement data (e.g. obtained by means of one or more sensors) is noisy and that has implications on the calculation of the derivatives (cf. derivative graphs).

Optionally, a low-pass filtering on the measured data is applied prior to the fitting processing.

Even a small deviation/error in the determination of the EMF curve can result in a significant error in derivative graphs. In practice, expensive measurement devices are often not available, and the data points are typically noisy and as a result deviations and/or errors may occur in the measurement data. Although noise filtering (e.g. low pass filter) could improve the results in the derivative graphs as the noise in the measurement data is reduced, it is often not sufficient. By employing the fitting model according to the invention, the dQ/dV (and/or dV/dQ) can be determined in a significantly more accurate way using the determined EMF curve. Since the fitting model is tailored for batteries, the noise effects can be effectively reduced or mitigated.

Optionally, the fitting function is a continuous function. The derivative of the continuous function can be easily determined and used in various applications. Advantageously, the fitting function is not ill-conditioned. The fitting function is well conditioned with only differentiable terms.

According to an aspect, the invention relates to a system for determining an electromotive force curve of a battery for use in battery control applications, the system comprising a signal processing unit configured to perform the steps of: receiving measured data identifying an electromotive force for a plurality of state of charge values of the battery; and performing fitting processing by using a curve fitting model for determining an electromotive force curve based on the measured data, the electromotive force curve indicating a continuous relationship between the electromotive force and a state of charge of the battery; and wherein the curve fitting model includes a fitting function consisting of only differentiable terms.

As a result of the improved fitting model, the derivative of the EMF versus SOC curve (e.g. d(EMF)/d(SoC) versus SoC) becomes significantly more accurate. A minimal deviation is obtained compared to measured data. In the known prior art, often significant errors occur in the derivative curves, even when there is a good fit of the EMF curve.

The ICA or dQ/dV (and/or dV/dQ) calculations can be of significant importance for the detection of the aging of the battery cells. Based on the peak shifts in derivative graphs, it is possible to predict the aging of the battery cell. By employing the fitting model according to the invention, a better prediction of the aging of the battery cell can be obtained in an effective way.

According to an aspect, the invention relates to a battery unit comprising a controller configured to receive data indicative of an electromotive force curve obtained by performing the computer implemented method according to the disclosure, wherein the controller is adapted to use the received data indicative of the electromotive force curve at a battery cell, battery module and/or battery pack level in battery control and/or analysis.

Advantageously, by using the curve fitting model according to the disclosure, an accurate EMF curve fit can be obtained. Based on the EMF curve fit, one or more further processing steps can be carried out involving calculating the derivative. Highly more accurate results can be obtained also for the further processing steps.

A smooth curve fit can be obtained using the fitting model. The fitting model includes a fitting function which is tailored for determining battery EMF curves based on measurement data. Even with noisy measurement data (e.g. as a result of the available sensor data), a highly accurate fitting of the EMF curve can be performed using the fitting model. Consequently, the derivative of the EMF curve can be calculated in a significantly more accurate way, which is highly advantageous in various applications related to battery control and/or analysis.

In some examples, the EMF curve fitting is performed at a single battery cell level. However, the method may also be applied for example at battery module level.

According to an aspect, the invention relates to an electrical system comprising a battery unit according to the disclosure.

The method and system according to the disclosure can be effectively used for real-time battery control applications and/or real-time battery state of charge analysis. The computer implemented modelling methodology may replace the EMF look-up table with a simplified fitting function (e.g. equation). This will help in accurately deriving the battery state information from the detailed EMF measured data including SoC, and the SoH estimation will become more accurate.

According to an aspect, the invention relates to a computer program product configured for performing, when run on a controller, the steps of the method according to the disclosure.

According to an aspect, the invention relates to a device, such as a controller, configured to perform the computer implemented steps of the disclosure.

According to an aspect, the invention provides for a software and battery management system in batteries.

According to an aspect, the invention relates to a non-transitory machine readable medium comprising instructions that, when executed, cause a machine to perform the method according to the disclosure.

According to an aspect, the invention provides for a computing system, comprising: at least one processor; and at least one non-transitory computer readable medium communicatively coupled to the at least one processor, the at least one non-transitory computer readable medium having stored thereon computer software comprising a set of instructions that, when executed by the at least one processor, causes the computing system to perform the method according to the disclosure.

According to an aspect, the invention provides for a curve fitting model as described herein.

It will be appreciated that the method and system according to the disclosure can be used for any type of battery cell chemistry.

The EMF curve can be understood as a EMF/SoC curve giving the EMF in function of the state of charge. It will be appreciated that the method and system according to the disclosure can be used for fitting curves of equivalent relationships.

It will be appreciated that any of the aspects, features and options described in view of the computer implemented method apply equally to the system and the described battery unit and electrical system. It will also be clear that any one or more of the above aspects, features and options can be combined.

BRIEF DESCRIPTION OF THE DRAWING

The invention will further be elucidated on the basis of exemplary embodiments which are represented in a drawing. The exemplary embodiments are given by way of non-limitative illustration. It is noted that the figures are only schematic representations of embodiments of the invention that are given by way of non-limiting example.

In the drawing:

Fig. 1 shows a schematic diagram of a method;
Fig. 2 shows a schematic diagram of a graph;
Fig. 3 shows a schematic diagram of a graph;
Fig. 4 shows a schematic diagram of a graph; and
Fig. 5 shows a schematic diagram of a graph.

DETAILED DESCRIPTION

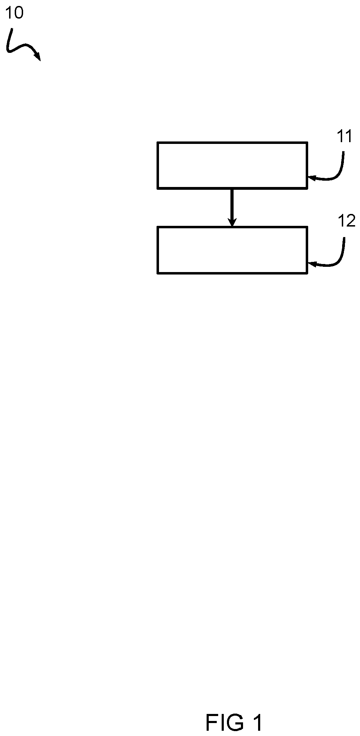

Fig. 1 shows a schematic diagram of a computer implemented method 10 of determining electromotive force curve of a battery for use in battery control and/or analysis. In a first step 11, measured data is received identifying an electromotive force for a plurality of state of charge values of the battery. In a second step 12, fitting processing is performed by using a curve fitting model for determining an electromotive force curve based on the measured data, the electromotive force curve indicating a continuous relationship between the electromotive force and a state of charge of the battery. The curve fitting model includes a fitting function consisting of only differentiable terms. By using only differentiable terms, the derivative can be more accurately determined, for instance for incremental capacity analysis (ICA) and/or state-of-charge (SoC) estimation.

In some examples, the fitting function of the curve fitting model includes a constant part, a linear part, an exponential part and a periodic part. Advantageously, the fitting model can be more tailored for battery applications such as incremental capacity analysis (ICA) and/or state-of-charge estimation.

The fitting function allows for an easy determination of the derivative. The terms of the fitting function can be easily differentiated.

The computer implemented method can be for example employed for lithium ion battery cells. However, it will be appreciated that the computer implemented method can also be used for other types of battery cells. Other battery chemistries such as Sodium ion batteries, Nickel-Metal Hydride batteries, Lead acid batteries, etc. can also be used.

Advantageously, by employing the fitting model, a large portion of inherent noises can be indirectly mitigated in the measurement data. Therefore, even noisy data can be used for obtaining an accurate fit of the EMF curve.

Since similar, but slightly different, elements may be needed to fit the EMF curve. The classic approach is to apply a curve fitting optimization method like a genetic algorithm. It appears that they become completely overwhelmed by the measurement data. Since the fitting elements are similar, it is like the expression is over-determined and the parameters jump in all directions. Even 10 million trials do not lead to a sufficient result.

Additionally, measured data (e.g. battery or cell voltage) are often subject to sensor noises; even with utilization of costly sensors, which can measure signals more accurately, small noises in measurements can result in large error in the derivative (rate) of the signal. As an example, small noise in the battery or cell voltage measurements can result in considerable errors in calculation of battery (or cell) Incremental Capacity Analysis.

In an example, a computer implemented method is applied for exact battery EMF curve determination comprising the steps of:

optionally applying minor low-pass filtering on the OCV measured data (to slightly remove noise) followed on both the measured voltage data and its derivative;

fitting the (filtered) EMF data simply with constant, linear and exponential terms and calculate fitting error;

using a fitting function (e.g. comprising differentiable terms such as Fourier series) to approximate the fitting error; the order of the harmonics (N) can be an important fitting parameter. For examples, the fitting functions according to the disclosure can be used. This step may result in N trigonometric terms (i.e. non-damped modes). The fitting error can be calculated;

fitting the residual fitting error of the previous step with a damped-trigonometric terms. This can be simply done by using a quick optimization algorithm (or even ad-hoc iterations). The best (final) error can be checked. The order N can be modified. If needed, the previous step can be repeated. In this way, a compromise can be made between the final error (SSE) of the OCV curve and complexity (cf. number of the damped/non-damped trigonometric components).

The above steps will result in diminishing the remaining error gradually until a satisfactory fit is obtained.

Advantageously, the results of the above steps will lead to a well-posed (across all SOC variation) differentiable compact fitting function, for example given in Eq. (1):

$$E(x) = \alpha_0 + \alpha_1 x + \sum_{k=0}^{N+1} r_k e^{\delta_k x} \cos(\omega_k x + \varphi_k)$$

where N is the order of the error Fourier approximation; a key design parameter that is to be selected based on the cell chemistry as well as the norm of accepted fitting error.

The above fitting function enables a highly effective way of battery EMF curve fitting. The equation can be used for obtaining an accurate EMF curve fit. In some examples, the order N is larger than 20, preferably larger than 28. Such order may be valid for most types of battery chemistries.

The proposed mathematical representation of Eq. (1) may be extracted to a more physics-oriented fitting model to highlight magnitude and phase of chemical behaviour in the cell at different frequencies, as given in Eq. (2):

$$E(x) = \alpha_0 + \alpha_1 x + \beta_0 e^{-\delta_0 x} + \beta_1 e^{-\delta_1 x} \cos(m_1 x + \theta_1) + \sum_{k=1}^{N} r_k \cos(k\omega x + \varphi_k)$$

where the damped and non-damped trigonometric terms of the OCV (EMF) data are decoupled.

The expanded expression of Eq. (2) may play the role of the EMF spectrum analyzer. Also, the effects of battery EMF changes due to e.g. temperature can also be modelled with updating parameters of the fixed/vector parameters in Eq. (1). Table 1 and Table 2 provide the parameters of an exemplary case study.

Exemplary simulation results

The computer implemented method according to the disclosure is effective for a wide range of battery chemistries including Lithium-ion cells.

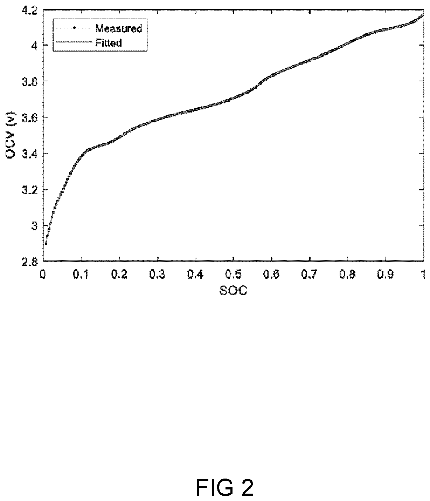

Fig. 2 illustrated an exemplary EMF curve, wherein a measurement EMF curve is compared to an EMF curve obtained by performing curve fitting according to the method of the disclosure. Fig. 2 shows a measured EMF data and its derived mathematical expression. As it can be seen, the mathematical expression (fitted in continuous line) is capturing the actual EMF measured data very well, and the EMF error is found to significantly small.

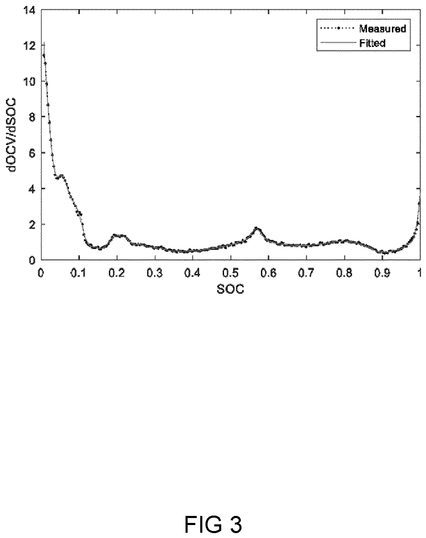

Fig. 3 shows a derivative of the EMF vs SOC curve (i.e. EMF curve), again based on measurement EMF curve and EMF curve obtained by performing curve fitting according to the method of the disclosure. Fig. 3 shows an derivative of the measured EMF data and its derived mathematical expression according to the disclosure. As important as the EMF error, the mathematical expression (i.e. fitted) is capturing the actual rate of the EMF measured data satisfactorily, confirmed by small d(EMF)/d(SOC) errors across the whole battery SOC range.

In some examples, one or more first values are calculated indicative of first errors in fitting the EMF curve, wherein one or more second values are calculated indicative of second errors in approximation of at least one of: d(Electromotive force)/d(State of Charge) curve or an incremental capacity analysis, wherein the one or more first values and one or more second values are calculated for different order N, and wherein the order N is selected based on the one or more first values and the one or more second values.

It is advantageous to keep into account errors in the EMF curve and error(s) in at least one derivative value, such as for instance derivative curves d(EMF)/d(SOC), d(V)/d(Q), d(Q)/d(V), etc, for the selection of the order N in the fitting function. In this way, not only data is fitted using the fitting function, but also the derivatives are validated It can be effectively avoided that the model would result in inaccurate derivative calculations, which is of great important for various applications (e.g. incremental capacity analysis, d(EMF)/d(SOC)). With other words, the order N can be selected not only based on the fitting of the EMF curve, but also the d(EMF)/d(SOC) curve, d(V)/d(Q), and/or d(Q)/d(V) compared to measurement data (for determining the error). An order N can be selected which adequately fits the EMF curve but also at the same time provides for adequate derivative calculations (cf. acceptable errors, for example falling within a range, smaller than a threshold, etc.). In some examples, the method includes finding a minimal order N which is giving acceptable results (cf. acceptable errors) for both the EMF fitting and for the calculated derivatives.

Optionally, the order N is selected as small as possible while the one or more first values fall within a first predetermined range and the one or more second values fall within a second predetermined range. In some examples, the one or more first values are compared to a first threshold value, and the one or more second values are compared to a second threshold value. For example, the smallest order N may be selected for which the one or more first and second values are sufficiently small (cf. first and second threshold values).

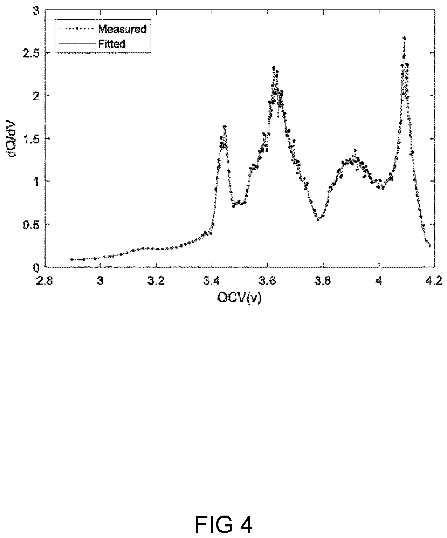

Fig. 4 shows an ICA analysis. The results obtained by performing a direct approach is indicated by a dotted line, and the results obtained by using the EMF curve by performing the method according to the disclosure (cf. differentiable mathematical expression) is indicated by a continuous line. Fig. 4 clearly shows that the incremental capacity analysis becomes much more precise than the classic, noise sensitive, approach.

In some examples, the error level are determined for both the EMF curve obtained by means of the fitting model and at least one derivative curve. The order N is selected such that not only the error levels for the EMF curve are within a predetermined range (cf. threshold), but also the error levels of the derivatives. Hence, the accuracy of the derivative calculations (e.g. derivative curve) are also taken into account for the selection of the order N. In this way, it is possible to reduce the effect of noise in an advantageous way, without using decoupled separate filtering applied on the measurement data.

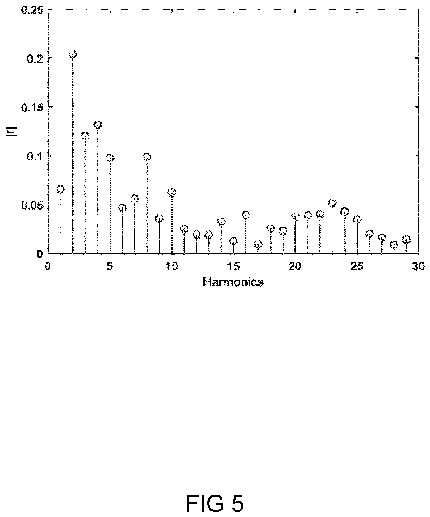

Fig. 5 illustrated a harmonic spectrum of the EMF data based on (non-damped) trigonometric components. Fig. 5 shows the spectrum (harmonics) analysis that is captured from the proposed mathematical EMF expression method (see e.g. Eq. (1) or (2)), using non-damping (trigonometric) terms only. As it can be see, the peaks of the harmonics are observed around the 2nd harmonics and the 23th harmonics.

For the given EMF data shown in Fig. 2, the mathematical expression of the EMF data using the Eq. (2) is given in Table 1 (scalar parameters) and in Table 2 (vector parameters).

Table 1: Scalar parameters of the proposed mathematical expression in Eq. (2) for OCV data of Fig. 2.

| $\alpha_0$ | $\alpha_1$ | $\omega_0$ | $N$ |
|---|---|---|---|
| 3.295 | 0.8685 | 6.325 | 29 |

Table 2: Vector parameters of the proposed mathematical expression in Eq. (2) for OCV data of Fig. 2.

| $k$ | $r_k$ | $\delta_k$ | $\dfrac{\omega_k}{\omega_1}$ | $\varphi_k$ | Damped mode |
|---|---|---|---|---|---|
| 0 | 0.5420 | 30.0 | 0 | 3.142 | Yes |

(continued)

| $k$ | $r_k$ | $\delta_k$ | $\dfrac{\omega_k}{\omega_1}$ | $\varphi_k$ | Damped mode |
|---|---|---|---|---|---|
| 1 | 0.0659 | 0 | 1 | 1.231 | No |
| 2 | 0.2039 | 0 | 2 | 1.533 | No |
| 3 | 0.1207 | 0 | 3 | -2.289 | No |
| 4 | 0.1318 | 0 | 4 | 1.003 | No |
| 5 | 0.0979 | 0 | 5 | 0.532 | No |
| 6 | 0.0470 | 0 | 6 | -2.505 | No |
| 7 | 0.0565 | 0 | 7 | 0.767 | No |
| 8 | 0.0991 | 0 | 8 | -2.734 | No |
| 9 | 0.0361 | 0 | 9 | -2.059 | No |
| 10 | 0.0627 | 0 | 10 | -1.697 | No |
| 11 | 0.0254 | 0 | 11 | 1.764 | No |
| 12 | 0.0194 | 0 | 12 | -1.119 | No |
| 13 | 0.0193 | 0 | 13 | -2.425 | No |
| 14 | 0.0329 | 0 | 14 | 0.228 | No |
| 15 | 0.0130 | 0 | 15 | 1.621 | No |
| 16 | 0.0398 | 0 | 16 | 1.243 | No |
| 17 | 0.0094 | 0 | 17 | -2.984 | No |
| 18 | 0.0257 | 0 | 18 | 1.446 | No |
| 19 | 0.0233 | 0 | 19 | 0.573 | No |
| 20 | 0.0378 | 0 | 20 | 1.573 | No |
| 21 | 0.0395 | 0 | 21 | 1.282 | No |
| 22 | 0.0404 | 0 | 22 | 1.809 | No |
| 23 | 0.0518 | 0 | 23 | 1.853 | No |
| 24 | 0.0432 | 0 | 24 | 2.580 | No |
| 25 | 0.0348 | 0 | 25 | 2.662 | No |
| 26 | 0.0203 | 0 | 26 | -3.102 | No |
| 27 | 0.0166 | 0 | 27 | -3.129 | No |
| 28 | 0.0091 | 0 | 28 | -2.968 | No |
| 29 | 0.0143 | 0 | 29 | -3.126 | No |
| 30 | 0.0489 | 9.57 | 7.304 | -0.655 | Yes |

As can be observed in the exemplary results and graphs, the method and system according to the disclosure can provide a significant improvement for various battery applications, such as for instance for battery real-time control applications. Advantageously, bulky EMF look-up table approaches used in the prior art can be replaced. Instead, a tailored made fitting model can be employed which utilizes a well-posed mathematical expression that consists of only differentiable exponential and trigonometric elements. Advantageously, this can help in deriving battery state information using the EMF data, which are typically subjected to sensor noises. The battery SoH estimation can become more accurate by means of the fitting function according to the disclosure.

It will be appreciated that the method may include computer implemented steps. All above mentioned steps can be computer implemented steps. Embodiments may comprise computer apparatus, wherein processes performed in computer apparatus. The invention also extends to computer programs, particularly computer programs on or in a carrier, adapted for putting the invention into practice. The program may be in the form of source or object code or in any other form suitable for use in the implementation of the processes according to the invention. The carrier may be any entity or device capable of carrying the program. For example, the carrier may comprise a storage medium, such as a ROM, for example a semiconductor ROM or hard disk. Further, the carrier may be a transmissible carrier such as an electrical or optical signal which may be conveyed via electrical or optical cable or by radio or other means, e.g. via the internet or cloud.

Some embodiments may be implemented, for example, using a machine or tangible computer-readable medium or article which may store an instruction or a set of instructions that, if executed by a machine, may cause the machine to perform a method and/or operations in accordance with the embodiments.

Various embodiments may be implemented using hardware elements, software elements, or a combination of both. Examples of hardware elements may include processors, microprocessors, circuits, application specific integrated circuits (ASIC), programmable logic devices (PLD), digital signal processors (DSP), field programmable gate array (FPGA), logic gates, registers, semiconductor device, microchips, chip sets, et cetera. Examples of software may include software components, programs, applications, computer programs, application programs, system programs, machine programs, operating system software, mobile apps, middleware, firmware, software modules, routines, subroutines, functions, computer implemented methods, procedures, software interfaces, application program interfaces (API), methods, instruction sets, computing code, computer code, et cetera.

Herein, the invention is described with reference to specific examples of embodiments of the invention. It will, however, be evident that various modifications, variations, alternatives and changes may be made therein, without departing from the essence of the invention. For the purpose of clarity and a concise description features are described herein as part of the same or separate embodiments, however, alternative embodiments having combinations of all or some of the features described in these separate embodiments are also envisaged and understood to fall within the framework of the invention as outlined by the claims. The specifications, figures and examples are, accordingly, to be regarded in an illustrative sense rather than in a restrictive sense. The invention is intended to embrace all alternatives, modifications and variations which fall within the scope of the appended claims. Further, many of the elements that are described are functional entities that may be implemented as discrete or distributed components or in conjunction with other components, in any suitable combination and location.

In the claims, any reference signs placed between parentheses shall not be construed as limiting the claim. The word 'comprising' does not exclude the presence of other features or steps than those listed in a claim. Furthermore, the words 'a' and 'an' shall not be construed as limited to 'only one', but instead are used to mean 'at least one', and do not exclude a plurality. The mere fact that certain measures are recited in mutually different claims does not indicate that a combination of these measures cannot be used to an advantage.

**Claims**

1. A computer implemented method of determining electromotive force curve of a battery for use in battery control and/or analysis, the method comprising:

    receiving measured data identifying an electromotive force for a plurality of state of charge values of the battery; and
    performing fitting processing by using a curve fitting model for determining an electromotive force curve based on the measured data, the electromotive force curve indicating a continuous relationship between the electromotive force and a state of charge of the battery; and
    wherein the curve fitting model includes a fitting function consisting of only differentiable terms.

2. The method according to claim 1, wherein the fitting function of the curve fitting model includes a constant part, a linear part, an exponential part and a periodic part.

3. The method according to claim 1 or 2, wherein the periodic part is represented by trigonometric terms, wherein the periodic part of the fitting function of the curve fitting model includes one or more damped trigonometric terms and one or more non-damped trigonometric terms.

4. The method according to any one of the preceding claims, wherein during the fitting processing a fitting error is calculated, and wherein parameters of the fitting function are adjusted in order to reduce the fitting error below a threshold fitting error value.

5. The method according to any one of the preceding claims, wherein the fitting function of the curve fitting model is given by:

$$E(x) = \alpha_0 + \alpha_1 x + \beta_0 e^{-\delta_0 x} + \beta_1 e^{-\delta_1 x} \cos(m_1 x + \theta_1) + \sum_{k=1}^{N} r_k \cos(k\omega x + \varphi_k)$$

wherein:

$E$ is the electromotive force; $x$ is the state of charge; $\alpha$, $r_k$ $\delta_k$, $\omega_k$, $\varphi_k$, $\beta$, and m are fitting parameters; and $N$ is an order.

6. The method according to any one of the preceding claims, wherein the fitting function of the curve fitting model is given by:

$$E(x) = \alpha_0 + \alpha_1 x + \sum_{k=0}^{N+1} r_k e^{\delta_k x} \cos(\omega_k x + \varphi_k)$$

wherein:
$E$ is the electromotive force; $x$ is the state of charge; $\alpha$, $r_k$, $\delta_k$, $\omega_k$ and $\varphi_k$ are fitting parameters; and $N$ is an order.

7. The method according to claim 5 or 6, wherein the order N is at least 8, preferably at least 10, even more preferably at least 15.

8. The method according to any one of the preceding claims 5-7, wherein the order N is selected based on a type of battery cell, wherein preferably N is in a range of 10 to 60, more preferably in a range of 15 to 45.

9. The method according to any one of the preceding claims 5-8, wherein fitting errors are calculated for multiple different orders N during the fitting processing.

10. The method according to any one of the preceding claims 5-9, wherein one or more first values are calculated indicative of first errors in fitting the EMF curve, wherein one or more second values are calculated indicative of second errors in approximation of at least one of: d(Electromotive force)/d(State of Charge) curve or an incremental capacity analysis, wherein the one or more first values and one or more second values are calculated for different order N, and wherein the order N is selected based on the one or more first values and the one or more second values.

11. The method according to any one of the preceding claims, wherein the determined battery electromotive force curve is usable for Incremental Capacity Analysis (ICA), wherein the incremental capacity analysis is based on a mathematical derivative of the fitting function.

12. The method according to any one of the preceding claims, wherein the determined battery electromotive force curve is usable for a state of charge (SOC) estimation and/or state of health (SOH) estimation of the battery.

13. A system for determining an electromotive force curve of a battery for use in battery control applications, the system comprising a signal processing unit configured to perform the steps of:

receiving measured data identifying an electromotive force for a plurality of state of charge values of the battery; and
performing fitting processing by using a curve fitting model for determining an electromotive force curve based on the measured data, the electromotive force curve indicating a continuous relationship between the electromotive force and a state of charge of the battery; and
wherein the curve fitting model includes a fitting function consisting of only differentiable terms.

14. A battery unit comprising a controller configured to receive data indicative of an electromotive force curve obtained by performing the computer implemented method according to any one of the preceding claims 1-12, wherein the controller is adapted to use the received data indicative of the electromotive force curve at a battery cell, battery module and/or battery pack level in battery control and/or analysis.

15. An electrical system comprising a battery unit according to claim 14.

10

11

12

FIG 1

FIG 2

FIG 3

FIG 4

FIG 5

Europäisches
Patentamt

European
Patent Office

Office européen
des brevets

# EUROPEAN SEARCH REPORT

Application Number

EP 21 21 5613

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | KAMAL E ET AL: "State of charge estimation based on extened Kalman filter algorithm for Lithium-Ion battery", 2015 23RD MEDITERRANEAN CONFERENCE ON CONTROL AND AUTOMATION (MED), IEEE, 16 June 2015 (2015-06-16), pages 734-739, XP033176502, DOI: 10.1109/MED.2015.7158833 [retrieved on 2015-07-14] | 1,2,11, 12 | INV. G01R31/367  ADD. G01R31/3835 G01R31/392 |
| A | * the whole document * | 3,5-10 | |
| X | CN 110 554 320 A (DONGFENG HANGSHENG WUHAN AUTOMOBILE CONTROL SYSTEM CO LTD) 10 December 2019 (2019-12-10) * equation 1.6; the whole document * | 1,2,11, 12 | |
| X | ADINOLFI F ET AL: "Performance evaluation of algorithms for the State of Charge estimation of storage devices in microgrid operation", 2016 POWER SYSTEMS COMPUTATION CONFERENCE (PSCC), POWER SYSTEMS COMPUTATION CONFERENCE, 20 June 2016 (2016-06-20), pages 1-8, XP032944030, DOI: 10.1109/PSCC.2016.7540851 [retrieved on 2016-08-10] | 1,2,4, 11-15 | |
| A | * II. Battery characterization; III. SOC estimation methods; equations 17,18 and 19; figures 3,4,7 * | 3,5-10 | TECHNICAL FIELDS SEARCHED (IPC)  G01R |
| X | CN 111 751 731 A (UNIV NORTHEAST PETROLEUM) 9 October 2020 (2020-10-09) * equation 9; paragraph [0092] - paragraph [0104]; claims 1,9 * | 1,2,11 | |

-/--

The present search report has been drawn up for all claims

| Place of search | Date of completion of the search | Examiner |
|---|---|---|
| Munich | 27 May 2022 | Hof, Klaus-Dieter |

EPO FORM 1503 03.82 (P04C01)

Europäisches
Patentamt

European
Patent Office

Office européen
des brevets

## EUROPEAN SEARCH REPORT

Application Number

EP 21 21 5613

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | FARMANN ALEXANDER ET AL: "Critical review of on-board capacity estimation techniques for lithium-ion batteries in electric and hybrid electric vehicles", JOURNAL OF POWER SOURCES, ELSEVIER, AMSTERDAM, NL, vol. 281, 22 January 2015 (2015-01-22), pages 114-130, XP029142623, ISSN: 0378-7753, DOI: 10.1016/J.JPOWSOUR.2015.01.129 * page 123 - page 124 * ----- | 11 | |

| | | | TECHNICAL FIELDS SEARCHED (IPC) |
|---|---|---|---|

The present search report has been drawn up for all claims

| Place of search | Date of completion of the search | Examiner |
|---|---|---|
| Munich | 27 May 2022 | Hof, Klaus-Dieter |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 21 21 5613

This annex lists the patent family members relating to the patent documents cited in the above-mentioned European search report.
The members are as contained in the European Patent Office EDP file on
The European Patent Office is in no way liable for these particulars which are merely given for the purpose of information.

27-05-2022

| Patent document cited in search report | | Publication date | Patent family member(s) | Publication date |
|---|---|---|---|---|
| CN 110554320 | A | 10-12-2019 | NONE | |
| CN 111751731 | A | 09-10-2020 | NONE | |

EPO FORM P0459